# EUROPEAN PATENT APPLICATION

(11) **EP 4 576 316 A1**
(43) Date of publication of application: **25.06.2025**
(21) Application number: 24220964.1
(22) Date of filing: 18.12.2024
(51) Int. Cl.: H01M 10/42, H01M 10/48, H01M 10/653, H01M 50/211, H01M 50/284, H01M 50/519

(54) **BATTERY PACK**

(30) Priority: 22.12.2023 CN 202311785664; 01.04.2024 CN 202420657622 U
(71) Applicant: AESC Japan Ltd., Kanagawa, 2520012 (JP)
(72) Inventor: BAO, Wenlai, Kangqiao Town, Pudong New Area Shanghai 201315 (CN); YANG, Mingping, Kangqiao Town, Pudong New Area Shanghai 201315 (CN); HE, Yafei, Kangqiao Town, Pudong New Area Shanghai 201315 (CN); CHEN, Chuanlian, Kangqiao Town, Pudong New Area Shanghai 201315 (CN); ZHAO, Nianbin, Kangqiao Town, Pudong New Area Shanghai 201315 (CN); GU, Jianchao, Kangqiao Town, Pudong New Area Shanghai 201315 (CN); WANG, Xinyu, Kangqiao Town, Pudong New Area Shanghai 201315 (CN)
(74) Representative: Becker, Eberhard

(57) **Abstract**

A battery pack includes: a casing, the casing includes a lower housing (101); a battery cell stack (102), the battery cell stack (102) includes multiple pouch battery cells, and the battery cell stack (102) is configured in the lower housing (101); a thermal conductive structural adhesive, the battery cell stack (102) and the bottom plate of the lower housing (101) are directly bonded and fixed through the thermal conductive structural adhesive; a foaming adhesive (105), the foaming adhesive (105) is filled and connected between the tab side of the battery cell stack (102) and the lower housing (101); a flexible printed circuit board assembly (200), the flexible printed circuit board assembly (200) includes: a flexible printed circuit board (201) and an insulating connecting sheet, the flexible printed circuit board (201) is fixedly connected to the battery cell stack (102) through the insulating connecting sheet.

## Description

### BACKGROUND

### Technical Field

The present disclosure relates to the technical field of power batteries, and specifically relates to a battery pack.

### Description of Related Art

The working voltage of a single secondary battery is approximately 2.5V to 4.5V. In electric vehicles or energy storage systems that require high capacity and high voltage output, it is normally required to connect multiple battery cells in series and/or parallel to form a battery module, and then connect the battery modules in series and/or parallel to form a battery pack, which is further utilized as an energy system for powering electric vehicles or as an energy storage system. The number and shape of battery modules used to build the battery pack, as well as the number and shape of battery cells used to compose the battery modules, may be flexibly varied according to actual needs.

In the field of power batteries used in electric vehicles, in order to improve the full-charge driving range and charging speed of electric vehicles, it is necessary to further enhance the energy density and cooling performance of the battery pack. As a solution to improve energy density, the CTP (cell to pack) type battery pack omits the step of forming battery modules from individual battery cells, and directly integrates the individual battery cells into a battery pack, thereby eliminating the structural components and electrical connection components required for forming battery modules, thus allowing for increased space for the battery cells themselves.

At present, common battery cells are categorized into cylindrical battery cells, prismatic battery cells, and pouch battery cells based on their structural differences. CTP (Cell-to-Pack) battery packs using prismatic battery cells have been widely developed and adopted. However, pouch battery cells, due to their disadvantages of poor resistance to external impacts and difficult assembly, still encounter a series of problems in the process of being integrated into CTP battery packs. In the existing technology, the direct configuration of pouch cell stacks within battery packs presents considerable challenges and results in suboptimal space utilization. Consequently, this leads to a diminished energy density of the battery pack.

### SUMMARY

In view of the aforementioned deficiencies in the existing technology, the purpose of the present disclosure is to provide a battery pack that offers improved spatial utilization, higher energy density, and enhanced ease of configuration.

In order to achieve the above purpose and other related purposes, the present disclosure provides a battery pack, including:
A casing, wherein the casing includes a lower housing;
A battery cell stack, wherein the battery cell stack includes multiple pouch battery cells, and the battery cell stack is configured in the lower housing;
A thermal conductive structural adhesive, wherein the battery cell stack and the bottom plate of the lower housing are directly bonded and fixed through the thermal conductive structural adhesive;
A foaming adhesive, wherein the foaming adhesive is filled and connected between the tab side of the battery cell stack and the lower housing;
A flexible printed circuit board assembly, wherein the flexible printed circuit board assembly includes: a flexible printed circuit board and an insulating connecting sheet, the flexible printed circuit board is fixedly connected to the battery cell stack through the insulating connecting sheet.

In an embodiment of the disclosure, the flexible printed circuit board includes a flexible printed circuit board body, wherein multiple sampling sheets are configured on the flexible printed circuit board body and distributed along the stacking direction of the pouch battery cells, and one of the sampling sheets is fixedly welded to a tab of corresponding one of the pouch battery cells.

In an embodiment of the disclosure, the insulating connecting sheet includes: a plastic sheet.

In an embodiment of the disclosure, the flexible printed circuit board body is located at the tab side of the battery cell stack. The plastic sheet includes a first fixing surface and a second fixing surface connected to each other. The second fixing surface is fitted and connected to the flexible printed circuit board body. The first fixing surface is fitted and connected to the upper surface of the battery cell stack to fix the flexible printed circuit board body.

In an embodiment of the disclosure, the first fixing surface is provided with multiple first openings. The first openings are located near the connection between the first fixing surface and the second fixing surface, and corresponds to one of the sampling sheets.

In an embodiment of the disclosure, the angle between the first fixing surface and the second fixing surface is equal to the angle formed between the upper surface of the battery cell stack and the surface on the tab side.

In an embodiment of the disclosure, the flexible printed circuit board body is adhesively fixed with the plastic sheet, and the plastic sheet is adhesively fixed with the battery cell stack.

In an embodiment of the disclosure, the insulating connecting sheet includes: a hot pressing film.

In an embodiment of the disclosure, the hot pressing film includes a first hot pressing film and a second hot pressing film. At least a part of the flexible printed circuit board body and at least a part of one of the sampling sheets are pressed between the first hot pressing film and the second hot pressing film.

In an embodiment of the present disclosure, the flexible printed circuit board body is located on the upper surface side of the battery cell stack; one end of one of the sampling sheets is fixedly connected to the flexible printed circuit board body, and the other end of one of the sampling sheets is bent to form a vertical part, the vertical part extends to the tab side of the battery cell stack, and a part of the vertical part extends beyond the first hot pressing film and the second hot pressing film and is fixedly welded to the tab of the corresponding one of the pouch battery cells.

In an embodiment of the present disclosure, the first hot pressing film and the second hot pressing film each include a first hot pressing surface and a second hot pressing surface, and the angle formed between the first hot pressing surface and the second hot pressing surface is equal to the angle formed between the upper surface of the battery cell stack and the surface on the tab side.

In an embodiment of the disclosure, multiple first protrusions are configured on the flexible printed circuit board body. The temperature sampling terminal is configured on the first protrusions. The first hot pressing film and the second hot pressing film are respectively located on the external side and the inner side of the flexible printed circuit board body, and the second protrusions corresponding to the first protrusions are configured on the first hot pressing film. The first protrusions are pressed by the second protrusions so that the temperature sampling terminal is configured on the upper surface of the battery cell stack, and the through holes corresponding to the temperature sampling terminal are configured on the second protrusions.

In an embodiment of the present disclosure, the side panels are further configured in the lower housing. The side panels are located on two sides of the battery cell stack along the stacking direction of the pouch battery cells. The two ends of the flexible printed circuit board body are bent in the same direction to form a fixing part stuck on the side panels.

In an embodiment of the disclosure, the flexible printed circuit board assembly further includes a first connector. The first connector is configured on the fixing part and is adapted to be electrically connected to the battery management system.

In an embodiment of the disclosure, the battery pack further includes: a temperature sampling terminal and a fixing plate, wherein the temperature sampling terminal is fixedly connected to the battery cell stack through the fixing plate.

In an embodiment of the disclosure, the two ends of the fixing plate extend along the stacking direction of the pouch battery cells within the battery cell stack, and are fixedly connected to corresponding one of the side panels.

In an embodiment of the disclosure, the flexible printed circuit board body is located at the tab side of the battery cell stack, and the temperature sampling terminal is located at the upper surface side of the battery cell stack. The flexible printed circuit board further includes multiple extending structures, and two ends of the extending structures are connected to the flexible printed circuit board body and the temperature sampling terminal respectively.

In an embodiment of the disclosure, a reinforcement plate is configured at one end of one of the extending structures connected to the temperature sampling terminal, and the reinforcement plate and the temperature sampling terminal are located on opposite sides of the one of the extending structures. The reinforcement plate faces the upper surface of the battery cell stack. The fixing plate is provided with a second opening corresponding to the temperature sampling terminal, and the fixing plate is pressed on the extending structures and/or the reinforcement plate and fits with the upper surface of the battery cell stack.

In an embodiment of the disclosure, the two ends of the fixing plate are bent in the same direction to form a bent structure, and the bent structure is fixedly connected with the side panels.

The present disclosure discloses a battery pack, which employs a plastic sheet to secure and position the flexible printed circuit board assembly, thereby preventing significant oscillation of the flexible printed circuit board during use. Compared to the use of plastic brackets or module upper and lower covers for fixation, the plastic sheets not only serve to position and secure the flexible printed circuit board but are also more cost-effective, easier to process, lighter in weight, and conserve material costs. This approach may reduce the overall cost of the battery pack, improve space utilization, enhance energy density, and simplify the assembly process. Furthermore, the perforations in the fixing sheets allow for the avoidance of tab welding fixtures.

The present disclosure discloses a battery pack, in which a fixing plate is configured to secure the temperature sampling terminal. During configuration of the sensor, the temperature sampling terminals are configured individually, followed by the direct configuration of the fixing plate. This configuration simplifies the manufacturing process. Furthermore, the fixing plate ensures more accurate positioning of the temperature sampling terminals, thereby enhancing sampling precision. Additionally, the fixing plate prevents displacement of the temperature sampling terminals during use.

The present disclosure discloses a battery pack, in which the hot pressing film defines the positions of the flexible printed circuit board and the sampling sheets, thereby eliminating the need for plastic brackets and upper and lower module covers. This configuration significantly reduces costs while simultaneously securing and insulating the flexible printed circuit board and the sampling sheets. During configuration, the assembly process is simplified. Furthermore, the temperature sampling terminal circuits are all hot-pressed within the hot pressing film, ensuring positional accuracy without the need for manual alignment by assembly personnel.

### BRIEF DESCRIPTION OF THE DRAWINGS

In order to more clearly illustrate the technical solutions of the embodiments of the present disclosure, the drawings required for describing the embodiments will be briefly introduced below. Clearly, the drawings in the following description are only some embodiments of the present disclosure. For those of ordinary skill in the art, other drawings can also be obtained based on these drawings without exerting creative efforts.
FIG. 1 is an exploded view of a battery pack in an embodiment of the present disclosure.
FIG. 2 is a schematic structural view of a flexible printed circuit board assembly in an embodiment of the present disclosure.
FIG. 3 is an exploded view of the flexible printed circuit board assembly in an embodiment of the present disclosure.
FIG. 4 is a schematic view of the configuration structure of one side of the flexible printed circuit board assembly in an embodiment of the present disclosure.
FIG. 5 is a schematic view of the configuration structure of the other side of the flexible printed circuit board assembly in an embodiment of the present disclosure.
FIG. 6 is a partially enlarged schematic view of the connector on the flexible printed circuit board in FIG. 5 according to an embodiment of the present disclosure.
FIG. 7 is a schematic structural view of a flexible printed circuit board assembly with temperature sampling terminals in an embodiment of the present disclosure.
FIG. 8 is an exploded view of a flexible printed circuit board assembly with temperature sampling terminals in an embodiment of the present disclosure.
FIG. 9 is a schematic view of the configuration structure of a flexible printed circuit board assembly with temperature sampling terminals in an embodiment of the present disclosure.
FIG. 10 is a partially enlarged schematic view of the fixing structure part in FIG. 9 according to an embodiment of the present disclosure.
FIG. 11 is a schematic view of the configuration structure of the temperature sampling terminals in an embodiment of the present disclosure.
FIG. 12 is a schematic structural view of a flexible printed circuit board assembly in another embodiment of the present disclosure.
FIG. 13 is an exploded view of a flexible printed circuit board assembly in another embodiment of the present disclosure.
FIG. 14 is a schematic view of the configuration structure of the flexible printed circuit board assembly in another embodiment of the present disclosure.
FIG. 15 is a top view of a flexible printed circuit board assembly in another embodiment of the present disclosure.
FIG. 16 is a partially enlarged schematic view of the configuration structure of the temperature sampling terminals in FIG. 15 according to another embodiment of the present disclosure.
FIG. 17 is a schematic structural view of a connecting component in an embodiment of the present disclosure.
FIG. 18 is a schematic view of the configuration structure of the connecting component in an embodiment of the present disclosure.
FIG. 19 is an exploded view of the connecting component in an embodiment of the present disclosure.
FIG. 20 is a top view of the connecting component in an embodiment of the present disclosure.
FIG. 21 is a partial enlarged schematic view of the fixation of the adapter sheet in the connecting component of FIG. 20 in an embodiment of the present disclosure.

### DESCRIPTION OF THE EMBODIMENTS

The implementation mode of the disclosure is illustrated below through specific examples. Those skilled in the art can easily understand other advantages and effects of the disclosure from the content disclosed in this specification. The disclosure may also be implemented or applied through other different specific implementation modes, and various details in this specification may also be modified or changed based on different views and applications without departing from the spirit of the disclosure.

It should be noted that the illustrations provided in this embodiment are only intended to explain the basic concept of the disclosure in a schematic manner. Therefore, the drawings only show components related to the disclosure rather than being drawn according to the actual number, shape, and size of components during implementation. In actual implementation, the form, quantity, and proportion of each component may be changed freely, and the layout pattern of the components may also be more complex.

In recent years, new energy vehicles have developed rapidly with increasing popularity, which has also accelerated the upgrading of related components and technologies. As an important component of new energy vehicles, more requirements are imposed on the power battery system increasingly for higher product performance, better safety, and lower cost under intense market competition. As a crucial part of new energy vehicles, the battery power system mainly includes a battery pack formed by connecting several individual battery cells in series and parallel, which may provide power source for the normal operation of the vehicle.

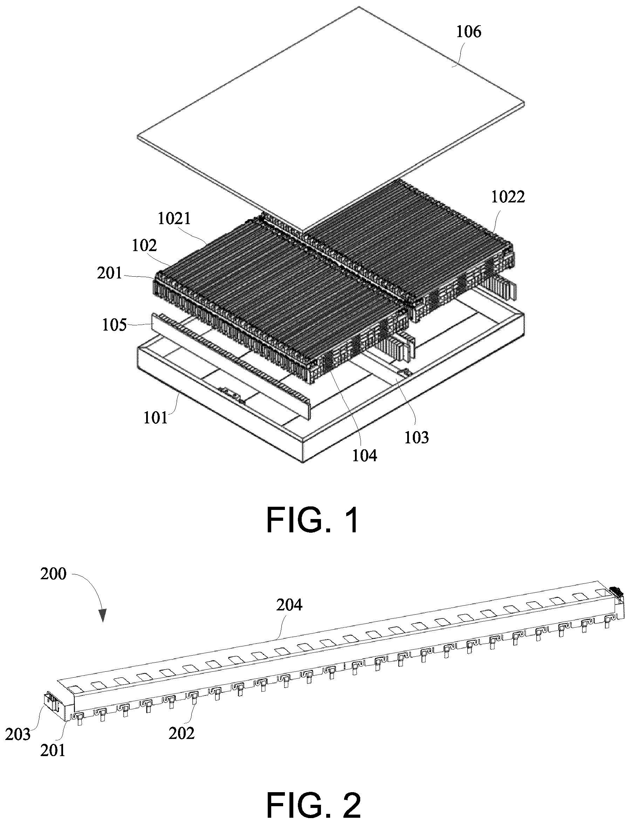

Please refer to FIG. 1. In an embodiment of the present disclosure, the battery pack includes: a casing, a battery cell stack 102, a thermally conductive structural adhesive, a foaming adhesive 105 and a flexible printed circuit board assembly 200. The casing includes a lower housing 101. The battery cell stack 102 includes multiple pouch battery cells and includes two opposite tab sides and a side surface adjacent to the tab side. The battery cell stack 102 is configured in the lower housing 101. The battery cell stack 102 and the bottom plate of the lower housing 101 are directly fixedly adhered by a thermally conductive structural adhesive. In other words, the battery cell stack 102 and the bottom plate of the lower housing 101 are directly fixedly adhered by a thermally conductive structural adhesive. The foaming adhesive 105 is filled and connected between the tab side of the battery cell stack 102 and the lower housing 101, and the foam adhesive 105 is formed by foaming, expanding and curing polyurethane and other materials. The flexible printed circuit board assembly 200 includes: a flexible printed circuit board 201 and an insulating connecting sheet. The flexible printed circuit board 201 is fixedly connected to the battery cell stack 102 through the insulating connecting sheet, wherein the thickness of and space occupied by the insulating connecting sheet are smaller than the conventional bracket used to connect and fix the flexible printed circuit board 201. That is, the battery pack includes a lower housing 101 and a battery cell stack 102 configured in the lower housing 101. The battery cell stack 102 is sequentially configured in the lower housing 101. A cavity may be formed between the lower housing 101 and the upper cover 106 on the top of the battery cell stack 102 to provide a closed receiving space for the battery cell stack 102. Each battery cell stack 102 includes multiple pouch battery cells, and the multiple pouch battery cells are sequentially stacked in the thickness direction of the battery cell to form the battery cell stack 102. When manufacturing the battery pack, the number of battery cell stacks 102 in each battery pack may be set according to user's needs. The higher the power supply capacity requirement that is imposed on the battery pack, the corresponding larger number of battery cell stacks 102 needs to be provided in the lower housing 101.

Please refer to FIG. 1. In an embodiment of the present disclosure, two battery cell stacks 102 are configured in the lower housing 101, namely a first battery cell stack 1021 and a second battery cell stack 1022. One of the tab sides of the first battery cell stack 1021 faces one of the tab sides of the second battery cell stack 1022. The two battery cell stacks 102 are separated by the casing middle beam 103. The foaming adhesive 105 is configured on two sides of the battery cell stack 102 and is located between the battery cell stack 102 and the lower housing 101. Specifically, the foaming adhesive 105 may be configured between one side of the battery cell stack 102 where the tab is configured and the side beam of the lower housing 101 and between one side of the battery cell stack 102 where the tab is configured and the casing middle beam 103. The battery cell stack 102 and the bottom plate of the lower housing 101 are directly fixedly adhered through the thermally conductive structural adhesive. One of the side panels 104 is also configured in the lower housing 101 and on the two sides of the battery cell stack 102. That is to say, the side panels 104 are located on the side surface of the battery cell stack 102, and the side surface is adjacent to the tab side of the battery cell stack 102. In other words, the side panels 104 are located on the side surface of the battery cell stack 102 perpendicular to the casing middle beam 103. The side panels 104 may be clamped tight by a tooling clamp to compress the battery cell stack 102 to a predetermined size and then placed into the lower housing 101.

Please refer to FIG. 1 and FIG. 2. In an embodiment of the present disclosure, a flexible printed circuit board assembly 200 is also configured in the battery pack. The flexible printed circuit board assembly 200 includes a flexible printed circuit board 201, sampling sheets 202, a first connector 203 and an insulating connecting sheet. In this embodiment, the insulating connecting sheet is a plastic sheet 204, and the flexible printed circuit board 201 is fixedly connected to the battery cell stack 102 through the insulating connecting sheet. Specifically, the plastic sheet 204 may be made of polyethylene glycol terephthalate (PET) or polycarbonate (PC) and other materials. A flexible printed circuit board 201 is configured on each of the two tab sides of each battery cell stack 102, monitoring the voltage, temperature, current output and other information of the battery cell stack 102 in real time.

Please refer to FIG. 2, FIG. 3 and FIG. 4. In an embodiment of the present disclosure, the flexible printed circuit board 201 is in the form of a bendable sheet. The flexible printed circuit board 201 includes a flexible printed circuit board body 2011. The flexible printed circuit board body 2011 may be located on the tab side of the battery cell stack 102, and the flexible printed circuit board body 2011 is attached to the tab side of the battery cell stack 102. In the disclosure, the two ends of the flexible printed circuit board body 2011 are bent in the same direction, and fixing parts 2012 are formed at two ends of the flexible printed circuit board body 2011. The fixing part 2012 may be stuck on the side panels 104. When the flexible printed circuit board 201 is assembled on the battery cell stack 102, the flexible printed circuit board body 2011 is adhered to the tab side of the battery cell stack 102 close to the foaming adhesive 105. The fixing parts 2012 at the two ends of the flexible printed circuit board body 2011 correspond to the side surface of the battery cell stack 102 close to the side panels 104.

Please refer to FIG. 2. In an embodiment of the present disclosure, the insulating connecting sheet includes: a plastic sheet 204. Multiple sampling sheets 202 are configured on each flexible printed circuit board 201. The multiple sampling sheets 202 are distributed along the stacking direction of the pouch battery cells, and multiple sampling sheets 202 are welded side by side on the flexible printed circuit board 201. Multiple sampling sheets 202 are located on one side of the flexible printed circuit board body 2011, and the other side of the flexible printed circuit board body 2011 is adhered to the plastic sheet 204. That is to say, the flexible printed circuit board body 2011 and the plastic sheet 204 are fixedly adhered, and the plastic sheet 204 is then fixedly adhered to the battery cell stack 102. The number of sampling sheets 202 is the same as the number of pouch battery cells in each battery cell stack 102. When the flexible printed circuit board 201 is assembled on the tab side of the battery cell stack 102, one of the sampling sheets 202 is welded and fixed correspondingly to the tab on the pouch battery cells. The sampling sheets 202 may be made of metal, such as a nickel sheet.

Please refer to FIG. 2, FIG. 5 and FIG. 6. In an embodiment of the present disclosure, a first connector 203 is further configured on the fixing part 2012 of the flexible printed circuit board 201. The flexible printed circuit board 201 is electrically connected to the battery management system 108 through the first connector 203 and the connecting wire. In this way, it is possible to monitor pouch battery cells. When the flexible printed circuit board 201 is assembled on the tab side of the battery cell stack 102, the fixing part 2012 of the flexible printed circuit board 201 is stuck on the snap fastener 107 of the side panels 104. Under the circumstances, the first connector 203 on the fixing part 2012 is engaged with the snap fastener 107 on the side panels 104, which may limit the position of the flexible printed circuit board 201.

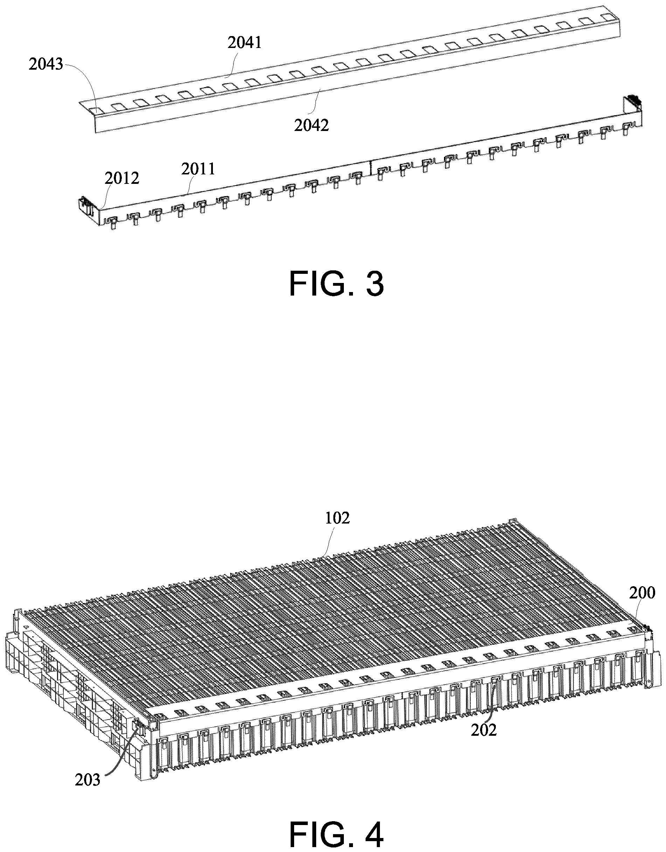

Please refer to FIG. 2 and FIG. 3. In an embodiment of the present disclosure, the plastic sheet 204 includes a first fixing surface 2041 and a second fixing surface 2042. The first fixing surface 2041 and the second fixing surface 2042 are connected together, and the first fixing surface 2041 and the second fixing surface 2042 are configured at a preset angle. The plastic sheet 204 may be made of plastic, and the first fixing surface 2041 and the second fixing surface 2042 are integrally formed. The angle between the first fixing surface 2041 and the second fixing surface 2042 is equal to the angle formed between the upper surface of the battery cell stack 102 and the surface on the tab side. It is possible to ensure that the first fixing surface 2041 is closely connected to the upper surface of the battery cell stack 102 during assembling, and the second fixing surface 2042 is closely connected to the flexible printed circuit board body 2011 assembled on the tab side of the battery cell stack 102 to fix the flexible printed circuit board body 2011. In this embodiment, the first fixing surface 2041 and the second fixing surface 2042 are arranged at a right angle, for example. In the disclosure, the upper surface of the battery cell stack 102 is a surface of the battery cell stack 102 facing the upper cover 106.

Please refer to FIG. 2 and FIG. 3. In an embodiment of the present disclosure, multiple first openings 2043 are also configured on the first fixing surface 2041 of the plastic sheet 204. The multiple first openings 2043 are arranged side by side on the first fixing surface 2041, and the first openings 2043 are close to the connection between the first fixing surface 2041 and the second fixing surface 2042. The number of the first openings 2043 is equal to the number of the sampling sheets 202, and the first openings 2043 are arranged corresponding to one of the sampling sheets 202. When one of the sampling sheets 202 is welded to the tab, the tooling may enter through the first openings 2043. This disclosure provides no limitation to the shape and size of the first openings 2043, as long as the first openings 2043 may be used to prevent tooling from entering during welding. The first openings 2043 may be configured in a rectangular, circular, oval or other arbitrary shape.

Please refer to FIG. 3. In an embodiment of the present disclosure, an adhesive (not shown) is further configured on the first fixing surface 2041 and the second fixing surface 2042, and located inside the bends of the first fixing surface 2041 and the second fixing surface 2042. The adhesive is double-sided adhesive, and the first fixing surface 2041 of the plastic sheet 204 is fixedly adhered to the upper surface of the battery cell stack 102, and the second fixing surface 2042 of the plastic sheet 204 is fixedly adhered to the flexible printed circuit board 201.

Please refer to FIG. 2 to FIG. 6. In an embodiment of the present disclosure, when assembling the flexible printed circuit board assembly 200, multiple sampling sheets 202 are welded on one side of the flexible printed circuit board 201, and the first connector 203 is assembled on the fixing part 2012 of the flexible printed circuit board 201. Moreover, the second fixing surface 2042 of the plastic sheet 204 and the flexible printed circuit board body 2011 are fixed through the adhesive. After the flexible printed circuit board assembly 200 is assembled, the flexible printed circuit board assembly 200 is assembled on the battery cell stack 102. Specifically, first, the first fixing surface 2041 of the plastic sheet 204 and the upper surface of the battery cell stack 102 are fixed through the adhesive. Thereafter, one of the sampling sheets 202 is welded to the tab of each of the pouch battery cells on the battery cell stack 102 through the first openings 2043. Finally, the fixing part 2012 of the flexible printed circuit board 201 is clamped through the opening on the side panels, and the first connector 203 on the fixing part 2012 is engaged with the snap fastener 107 on the side panels.

Please refer to FIG. 3, FIG. 7 to FIG. 11. In an embodiment of the present disclosure, the battery pack further includes: a temperature sampling terminal 205 and a fixing plate 207. The temperature sampling terminal 205 is fixedly connected to the battery cell stack 102 through the fixing plate 207. In order to collect the temperature of each of the pouch battery cells, a temperature sampling terminal 205 is further configured in the battery pack. The flexible printed circuit board body 2011 is located on the tab side of the battery cell stack 102, and the temperature sampling terminal 205 is located on the upper surface side of the battery cell stack 102. The temperature sampling terminal 205 is electrically connected to the flexible printed circuit board 201. In the disclosure, the flexible printed circuit board 201 further includes multiple extending structures 2013. The multiple extending structures 2013 are connected to the flexible printed circuit board body 2011. That is to say, the two ends of the extending structures 2013 are respectively connected to the flexible printed circuit board body 2011 and the temperature sampling terminal 205. The position of the extending structures 2013 may be defined according to the collection requirements and the overall structure of the battery pack. In this embodiment, multiple extending structures 2013 are arranged side by side on the plane where the first fixing surface 2041 of the plastic sheet 204 is located or on the upper surface of the battery cell stack 102, and one end of one of the extending structures 2013 is connected to the flexible printed circuit board body 2011, the other end thereof is connected to the temperature sampling terminal 205. In addition, a reinforcement plate 206, a temperature sampling terminal 205 and a fixing plate 207 are further configured in the flexible printed circuit board assembly 200. The fixing plate 207 may be pressed on the extending structures 2013 and/or the reinforcement plate 206 and adhered to the upper surface of the battery cell stack 102.

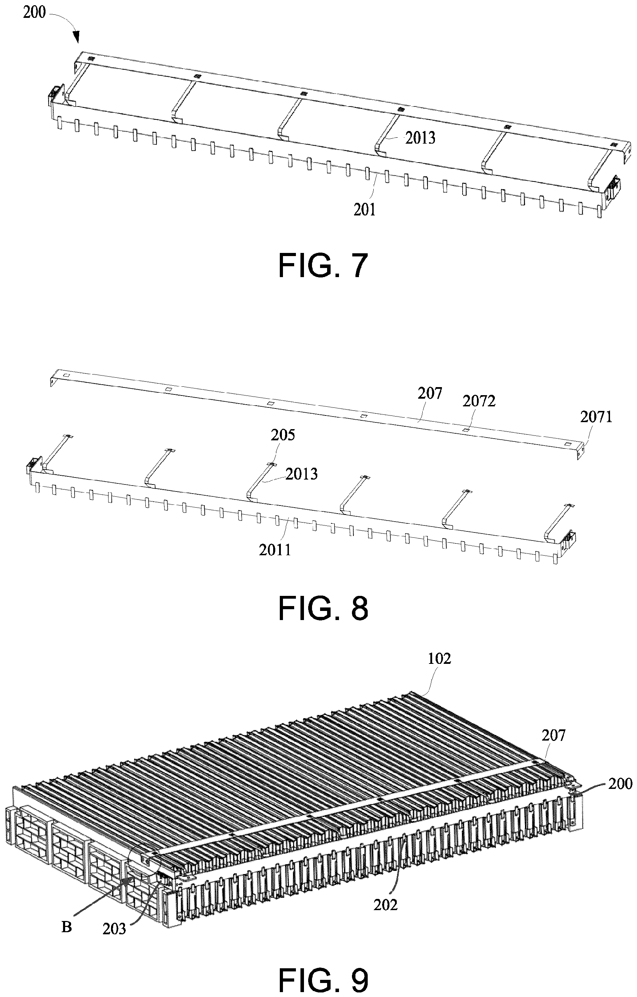

Please refer to FIG. 7 to FIG. 9. In an embodiment of the present disclosure, the temperature sampling terminal 205 is connected to the flexible printed circuit board 201 and is located at the other end of one of the extending structures 2013. The temperature sampling terminal 205 is in contact with the pouch battery cells in the battery cell stack 102, collects the temperature of the pouch battery cells, and transmits the temperature information to the battery management system 108 through the flexible printed circuit board 201 to monitor the temperature of the pouch battery cells and ensure safe operation of the system.

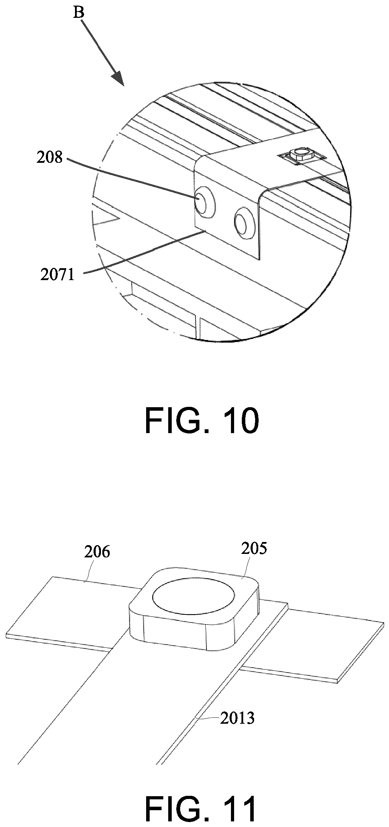

Please refer to FIG. 8 and FIG. 11. In an embodiment of the present disclosure, a reinforcement plate 206 is configured on the extending structures 2013 of the flexible printed circuit board 201. The reinforcement plate 206 is configured at one end of one of the extending structures 2013 connected to the temperature sampling terminal 205. The reinforcement plate 206 and the temperature sampling terminal 205 are located on two sides of the extending structures 2013, and the reinforcement plate 206 is close to the pouch battery cells. That is to say, the reinforcement plate 206 and the temperature sampling terminal 205 are located on opposite sides of the extending structures 2013, and the reinforcement plate 206 faces the upper surface of the battery cell stack 102. The temperature sampling terminal 205 extends from two ends of the reinforcement plate 206 to facilitate connection with the fixing plate 207.

Please refer to FIG. 8, FIG. 9 and FIG. 10. In an embodiment of the present disclosure, the fixing plate 207 is configured on the upper surface of the battery cell stack 102 and is placed along the thickness direction of the pouch battery cells. The fixing plate 207 is fixedly connected to the reinforcement plate 206 on one side of each temperature sampling terminal 205, thereby fixing the multiple temperature sampling terminals 205 on the fixing plate 207. The two ends of the fixing plate 207 are bent toward the same side to form a bent structure 2071. When the fixing plate 207 is assembled on the upper surface of the battery cell stack 102, the bent structure 2071 corresponds to two side surfaces of the battery cell stack 102. A through hole is configured on the bent structure 2071, and the fixing structure 208 may be used to fixedly connect the fixing plate 207 to the side panels on the two sides of the battery cell stack 102 to fix the multiple temperature sampling terminals 205. That is to say, the two ends of the fixing plate 207 extend along the stacking direction of the pouch battery cells in the battery cell stack 102 and are fixedly connected to corresponding one of the side panels 104. Specifically, the bent structure 2071 is fixedly connected to the side panels 104. The fixing structure 208 is, for example, a rivet or other fixing structure.

Referring to FIG. 8 and FIG. 9, in an embodiment of the present disclosure, multiple second openings 2072 are configured on the fixing plate 207. The number of the second openings 2072 is the same as the number of the temperature sampling terminals 205. The position of the second openings 2072 corresponds to the position of the temperature sampling terminals 205. When the fixing plate 207 is placed on the upper surface of the battery cell stack 102, the temperature sampling terminals 205 pass through the second openings 2072 to the surface of the fixing plate 207.

Please refer to FIG. 8 to FIG. 11. In an embodiment of the present disclosure, an adhesive (not shown) is configured on the fixing plate 207. On the one hand, the adhesive on the fixing plate 207 may be fixedly connected to the two sides of the reinforcement plate 206. That is to say, the fixing plate 207 may be pressed on the reinforcement plate 206 to fix the temperature sampling terminal 205 on the reinforcement plate 206, and the temperature sampling terminal 205 passes through the second opening 2072 on the fixing plate 207 to the surface of the fixing plate 207. On the other hand, after the fixing plate 207 is fixedly connected to the temperature sampling terminal 205, the fixing plate 207 may be fixedly connected to the pouch battery cells through the adhesive on the fixing plate 207. That is to say, the fixing plate 207 may be adhered to the upper surface of the battery cell stack 102.

Please refer to FIG. 7 to FIG. 11. In an embodiment of the present disclosure, when assembling the flexible printed circuit board assembly 200, after the sampling sheets 202 and the first connector 203 are assembled with the flexible printed circuit board 201, the reinforcement plate 206 and the temperature sampling terminal 205 on the reinforcement plate 206 are assembled on the flexible printed circuit board 201. After that, the fixing plate 207 and the reinforcement plate 206 are fixedly connected through the adhesive, and finally the flexible printed circuit board assembly 200 is assembled on the battery cell stack 102. The fixing plate 207 and the battery cell stack 102 may be fixed with the adhesive, and the sampling sheets 202 may be welded to the tab of each of the pouch battery cells on the battery cell stack 102. Finally, the fixing part 2012 of the flexible printed circuit board 201 is clamped through the opening on the side panels 104, and the first connector 203 on the fixing part 2012 is engaged with the snap fastener 107 on the side panels.

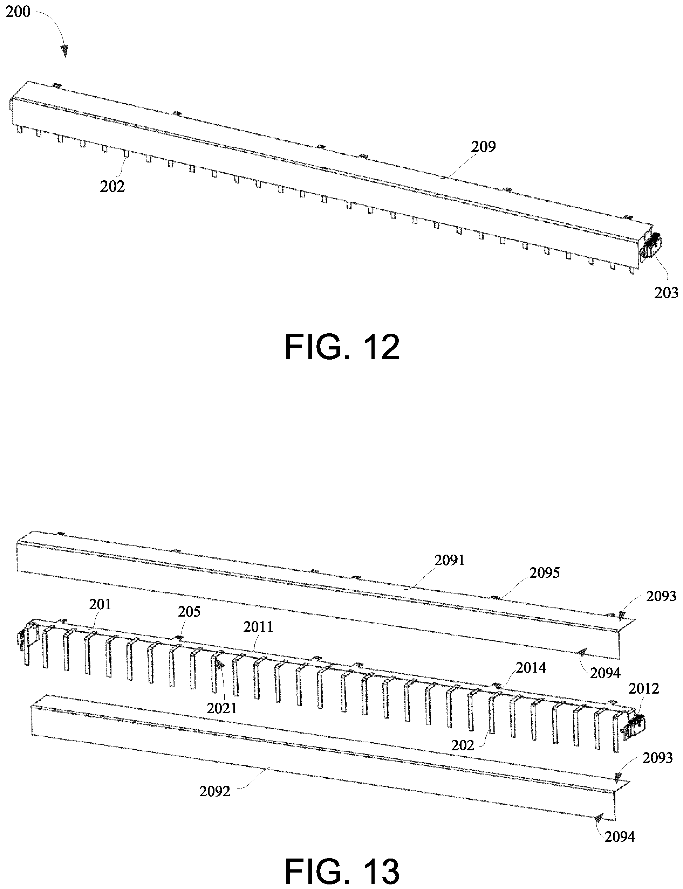

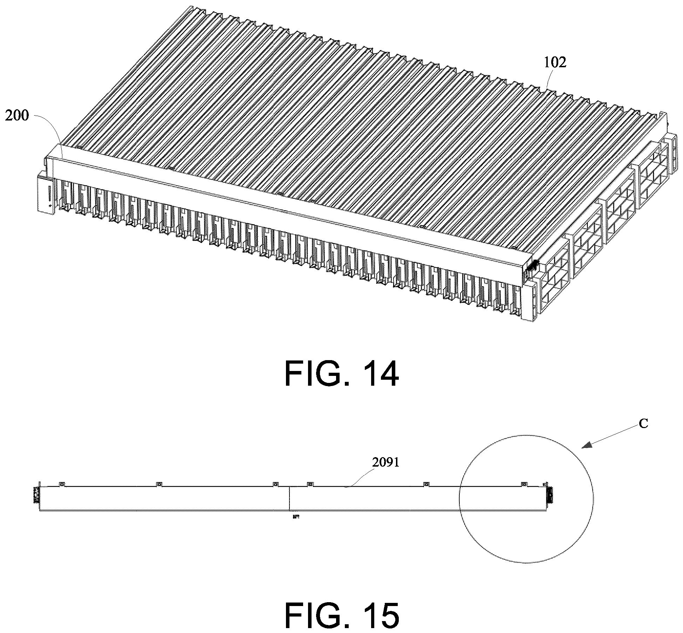

Referring to FIG. 12 to FIG. 16, in another embodiment of the present disclosure, another flexible printed circuit board assembly 200 is provided. The insulating connecting sheet includes: a hot pressing film 209. One of the sampling sheet 202 is fixed on the flexible printed circuit board 201. The hot pressing film 209 includes a first hot pressing film 2091 and a second hot pressing film 2092. At least a part of the flexible printed circuit board 201 and at least a part of one of the sampling sheets 202 are pressed between the first hot pressing film 2091 and the second hot pressing film 2092. The first hot pressing film 2091 and the second hot pressing film 2092 insulatingly fix the flexible printed circuit board 201 and the sampling sheets 202.

Please refer to FIG. 12 to FIG. 14. In another embodiment of the present disclosure, the flexible printed circuit board body 2011 is adhered to the upper surface of the battery cell stack 102. The two ends of the flexible printed circuit board body 2011 are bent in the same direction, and fixing parts 2012 are formed at the two ends of the flexible printed circuit board body 2011. When the flexible printed circuit board 201 is assembled on the battery cell stack 102, the flexible printed circuit board body 2011 is adhered to the upper surface of the battery cell stack 102, and the fixing parts 2012 at the two ends of the flexible printed circuit board body 2011 correspond to the side surface of the battery cell stack 102.

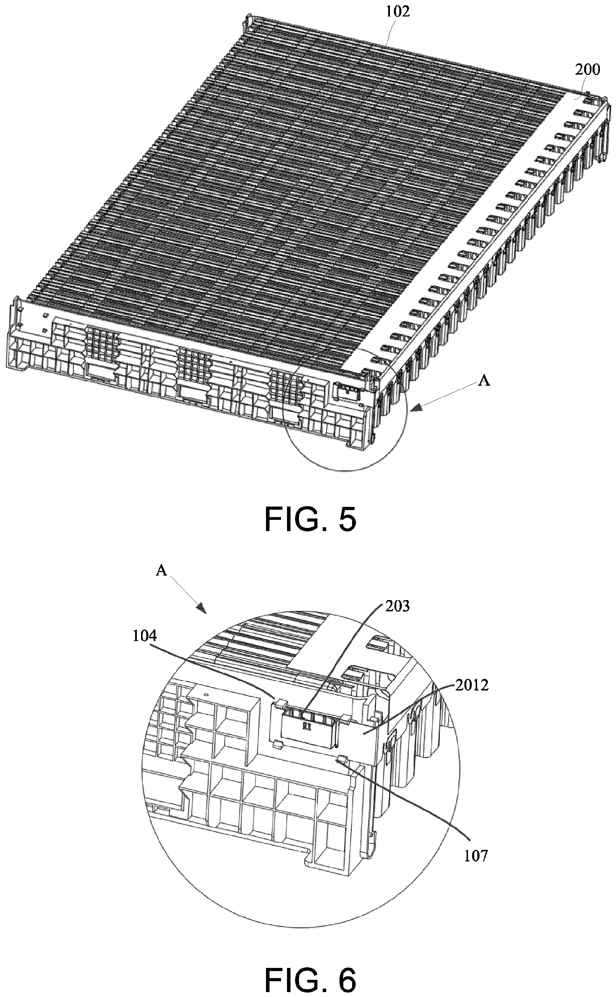

Please refer to FIG. 12 and FIG. 13. In another embodiment of the present disclosure, a first connector 203 is further configured on the fixing part 2012 of the flexible printed circuit board 201. The flexible printed circuit board 201 is electrically connected to the battery management system 108 through the first connector 203 and the connecting wire. In this way, it is possible to monitor the pouch battery cells. With reference to FIG. 6, when the flexible printed circuit board 201 is assembled on the upper surface of the battery cell stack 102, the fixing part 2012 of the flexible printed circuit board 201 is stuck on the snap fastener 107 of the side panels 104. Under the circumstances, the first connector 203 on the fixing part 2012 is engaged with the snap fastener 107 on the side panels, so that the position of the flexible printed circuit board 201 may be defined.

Please refer to FIG. 12 to FIG. 14. In another embodiment of the present disclosure, multiple sampling sheets 202 are configured on each flexible printed circuit board 201, and the multiple sampling sheets 202 are welded side by side on the flexible printed circuit board body 2011. The multiple sampling sheets 202 are located on one side of the flexible printed circuit board body 2011. In this embodiment, the flexible printed circuit board body 2011 is located on the upper surface side of the battery cell stack 102. One end of one of the sampling sheets 202 is fixedly connected to the flexible printed circuit board body 2011, and the other end thereof is bent in the same direction to form a vertical part 2021. When the flexible printed circuit board body 2011 is insulatingly adhered to the upper surface of the battery cell stack 102 through the hot pressing film 209, a part of one of the sampling sheets 202 is insulatingly adhered to the upper surface of the battery cell stack 102 through the hot pressing film 209, and the other part thereof is insulatingly adhered to the tab side of the battery cell stack 102 through the hot pressing film 209. The other end of one of the sampling sheets 202 is bent and extended to the position where the tab of the pouch battery cells is located. That is to say, the vertical part 2021 extends to the tab side of the battery cell stack 102, and a part of the vertical part 2021 extends beyond the first hot pressing film 2091 and the second hot pressing film 2092 and fixedly welded on the tab of the corresponding one of the pouch battery cells. The number of one of the sampling sheets 202 is the same as the number of pouch battery cells in each battery cell stack 102. When the flexible printed circuit board 201 is assembled on the upper surface of the battery cell stack 102, the other end of one of the sampling sheet 202 corresponds to the tab on the pouch battery cells. The sampling sheets 202 are made of metal, such as a nickel sheet.

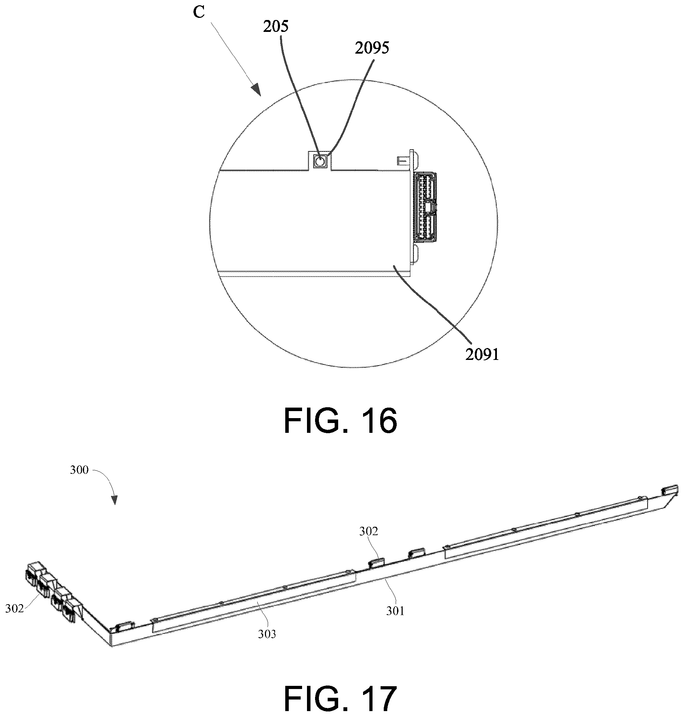

Referring to FIG. 13 and FIG. 16, in another embodiment of the present disclosure, multiple first protrusions 2014 are configured on each flexible printed circuit board 201. The first protrusions 2014 and the sampling sheets 202 are located on opposite sides of the flexible printed circuit board body 2011. The temperature sampling terminal 205 is configured on the first protrusions 2014. By disposing the temperature sampling terminal 205 on the first protrusions 2014, it is possible to detect the temperature of the pouch battery cells. The number of first protrusions 2014 is the same as the number of temperature sampling terminals 205, and the position of the first protrusions 2014 is set corresponding to the position of the temperature sampling terminal 205, that is, the temperature sampling terminal 205 is configured on the upper surface of the battery cell stack 102. When the temperature sampling terminal 205 is configured on the first protrusions 2014, the temperature of the pouch battery cells to be sampled may be sampled.

Please refer to FIG. 13 and FIG. 16. In another embodiment of the present disclosure, the shapes of the first hot pressing film 2091 and the second hot pressing film 2092 are adapted to the shapes of the flexible printed circuit board 201 and the sampling sheets 202. In this embodiment, the first hot pressing film 2091 is configured on the vertical part 2021 of the sampling sheets 202 and the outside of the flexible printed circuit board body 2011, and the second hot pressing film 2092 is configured on the vertical part 2021 of the sampling sheets 202 and the inside of the flexible printed circuit board body 2011. The first hot pressing film 2091 and the second hot pressing film 2092 include a first hot pressing surface 2093 and a second hot pressing surface 2094. The first hot pressing surface 2093 and the second hot pressing surface 2094 are configured at a preset angle, and the angle formed between the first hot pressing surface 2093 and the second hot pressing surface 2094 is equal to the angle of the vertical part 2021 on the sampling sheets 202 and the angle between the upper surface of the battery cell stack 102 and the surface on the tab side. When the first hot pressing film 2091 and the second hot pressing film 2092 are pressed against the flexible printed circuit board 201 and the sampling sheets 202, the edge of the first hot pressing surface 2093 coincides with the edge of the flexible printed circuit board body 2011, and the edge of the second hot pressing surface 2094 exposes the other end of the sampling sheets 202. In order to protect the temperature sampling terminal 205, multiple second protrusions 2095 are configured on the first hot pressing film 2091. The second protrusions 2095 on the first hot pressing film 2091 corresponds to the first protrusions 2014 on the flexible printed circuit board 201. When the first hot pressing film 2091 is attached to the flexible printed circuit board 201, the second protrusions 2095 on the first hot pressing film 2091 is attached to the first protrusions 2014 on the flexible printed circuit board 201, that is to say, the first protrusions 2014 are pressed by the second protrusions 2095 so that the temperature sampling terminal 205 is able to be configured on the upper surface of the battery cell stack 102 to perform temperature sampling on the pouch battery cells that need to be sampled. Moreover, the second protrusions 2095 are provided with multiple through holes, and the through holes expose the temperature sampling terminal 205 configured on the first protrusions 2014.

Please refer to FIG. 12 to FIG. 16. In another embodiment of the present disclosure, when assembling the flexible printed circuit board assembly 200, multiple sampling sheets 202 are welded on one side of the flexible printed circuit board 201, and the first connector 203 is assembled on the fixing part 2012 of the flexible printed circuit board 201. Then the first hot pressing film 2091 and the second hot pressing film 2092 are pressed against the flexible printed circuit board 201 and the sampling sheets 202. The sampling sheets 202 are bent to form the vertical part 2021 on one of the sampling sheets 202. The hot pressing film 209 is fixed on the upper surface of the battery cell stack 102 through the adhesive. The other end of one of the sampling sheets 202 exposed by the hot pressing film 209 is welded on the tab of each of the pouch battery cells on the battery cell stack 102. Finally, the fixing part 2012 of the flexible printed circuit board 201 is clamped through the opening on the side panels, and the first connector 203 on the fixing part 2012 is engaged with the snap fastener 107 on the side panels.

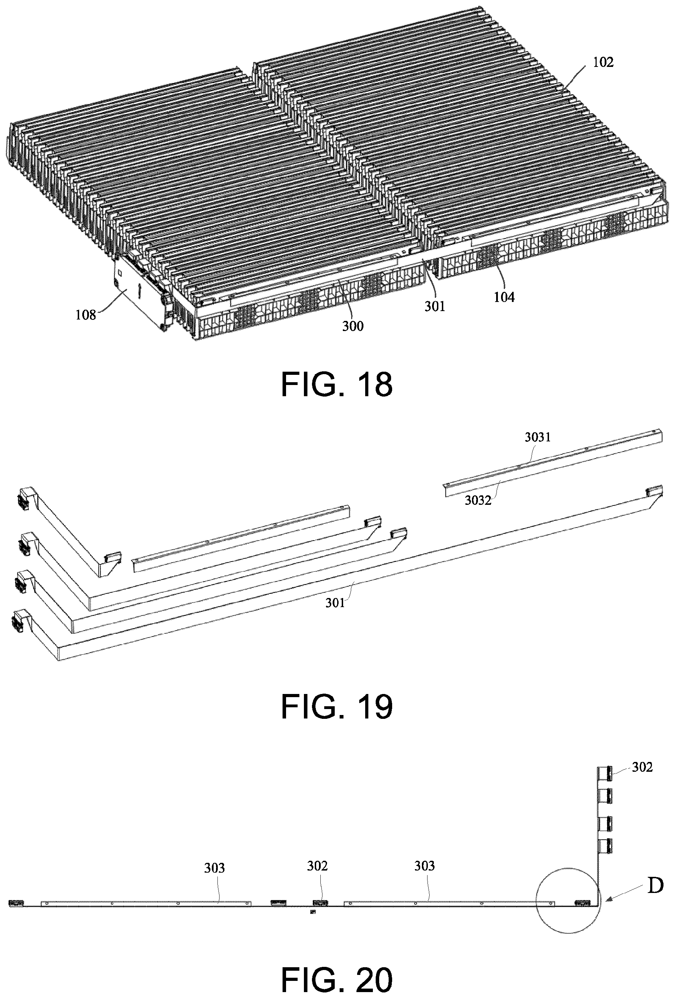

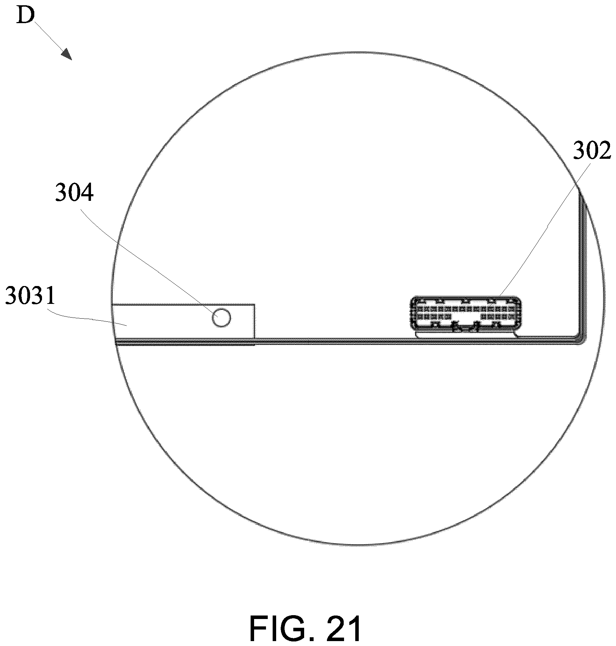

Please refer to FIG. 17 to FIG. 21, and as shown in FIG. 1 and FIG. 4, in an embodiment of the present disclosure, the battery pack further includes: a connecting component 300, a battery management system 108 and side panels 104. The flexible printed circuit board 201 is communicatively connected to the battery management system 108 through the connecting component 300, the side panels 104 are fixed on the side surface of the battery cell stack 102, and the connecting component 300 is fixedly connected to the side panels 104. The connecting component 300 includes: a flexible flat cable 301 and an adapter sheet 303. The flexible flat cable 301 is configured on the side surface of the battery cell stack 102 and is fixedly connected to the side panels 104 through the adapter sheet 303. That is to say, the flexible flat cable 301 is configured corresponding to the side surface of the battery cell stack 102. A connecting component 300 is further provided. One end of the connecting component 300 is electrically connected to the first connector 203 of the flexible printed circuit board 201, and the other end thereof is connected to the battery management system 108 to realize signal transmission. The connecting component 300 includes a flexible flat cable 301, a second connector 302 and an adapter sheet 303. The flexible flat cable 301 is fixed on the side panels 104 through the adapter sheet 303.

Please refer to FIG. 4, FIG. 17 and FIG. 18. In an embodiment of the present disclosure, the two ends of the flexible flat cable 301 are connected to the second connector 302, that is, the two ends of the flexible flat cable 301 are both connected to the second connector 302. The second connector 302 at one end of the flexible flat cable 301 is connected to the first connector 203 on the flexible printed circuit board 201, and the second connector 302 at the other end of the flexible flat cable 301 is electrically connected to the battery management system 108. In the disclosure, the number of flexible flat cables 301 may be multiple, and the number of flexible flat cables 301 is equal to the number of flexible printed circuit boards 201. The battery pack includes a first battery cell stack and a second battery cell stack. One of the tab sides of the first battery cell stack faces one of the tab sides of the second battery cell stack. The battery management system 108 is located on the other tab side of the first battery cell stack facing away from the second battery cell stack. One end of the each of the multiple flexible flat cables 301 is connected to the corresponding flexible printed circuit board 201, and the other end of each of the the multiple flexible flat cables 301 extends across the side surface of the first battery cell stack and/or the side surface of the second battery cell stack and is electrically connected to the same battery management system 108. In this embodiment, if it is necessary to transmit signals from four flexible printed circuit boards 201 in each battery pack, then four flexible flat cables 301 are provided, for example. The length and folding method of each flexible flat cable 301 may be folded as required. The second connectors 302 on the multiple flexible flat cables 301 are staggered in the extending direction of the flexible flat cables 301. In the embodiment, the flexible flat cable 301 is configured corresponding to the side surface of the battery cell stack 102, and extends along the side surface of the battery cell stack 102 from the first connector 203 on the flexible printed circuit board 201 to the battery management system 108. That is, one end of the flexible flat cable 301 is connected to the first connector 203 on the corresponding flexible printed circuit board 201, and the other end of the flexible flat cable 301 is extended to the battery management system 108. Moreover, on the repeated path, multiple flexible flat cables 301 are configured in an overlapped manner, that is to say, at least part of the multiple flexible flat cables 301 are configured in a stack, and are fixedly connected to the side panels 104 through the same adapter sheet 303. Specifically, multiple flexible flat cables 301 are stacked on the same path.

Please refer to FIG. 17, FIG. 19, FIG. 20 and FIG. 21. In an embodiment of the present disclosure, the adapter sheet 303 includes a first connecting surface 3031 and a second connecting surface 3032, and the first connecting surface 3031 and the second connecting surface 3032 are set at a preset angle. During assembling, the first connecting surface 3031 is overlapped on the side panels 104 and is fixed through the fastener 304. That is to say, the first connecting surface 3031 may be fixedly connected to the side panels 104; the second connecting surface 3032 is fixedly connected to the flexible flat cable 301 through the adhesive. That is to say, the second connecting surface 3032 may be fixedly connected to the flexible flat cable 301. In this embodiment, the first connecting surface 3031 and the second connecting surface 3032 are configured at a right angle, for example. The fastener 304 may be, for example, a rivet or other fasteners.

Please refer to FIG. 1, FIG. 17 to FIG. 21. In an embodiment of the present disclosure, when assembling the connecting component 300, the second connectors 302 at the two ends of each flexible flat cable may be connected to the corresponding first connector 203 and the battery management system first. Next, the multi-layer flexible flat cables 301 are overlapped, and the adjacent flexible flat cables 301 are fixed with the adhesive. That is to say, two adjacent layers of flexible flat cables 301 may be fixed to each other with the adhesive, so that the multi-layer flexible flat cable 301 is formed as a whole. Finally, the adapter sheet 303 is assembled, the second connecting surface 3032 of the adapter sheet 303 is fixed on the flexible flat cable 301 through the adhesive, then the first connecting surface 3031 of the adapter sheet 303 is overlapped on the side panels, and the fastener 304 and the like is adopted to secure the first connecting surface 3031 and the side panels 104.

In summary, the disclosure provides a battery pack, including a lower housing, a battery cell stack configured in the lower housing, flexible printed circuit boards configured on two sides of each battery cell stack, a connecting component including a flexible flat cable, a plastic sheet or a hot pressing film that fixes the flexible printed circuit board, and a fixing plate that fixes the temperature sampling terminal. The battery pack provided by the disclosure does not require a separate bracket structure for the flexible printed circuit board and the like, thereby making it possible to improve the volume utilization and energy density of the battery pack.

## Claims

1. A battery pack, comprising:
a casing, wherein the casing comprises a lower housing (101);
a battery cell stack (102), wherein the battery cell stack (102) comprises a plurality of pouch battery cells, and the battery cell stack (102) is configured in the lower housing (101);
a thermal conductive structural adhesive, wherein the battery cell stack (102) and a bottom plate of the lower housing (101) are directly bonded and fixed through the thermal conductive structural adhesive;
a foaming adhesive (105), wherein the foaming adhesive (105) is filled and connected between a tab side of the battery cell stack (102) and the lower housing (101);
a flexible printed circuit board assembly (200), wherein the flexible printed circuit board assembly (200) comprises a flexible printed circuit board (201) and an insulating connecting sheet, and the flexible printed circuit board (201) is fixedly connected to the battery cell stack (102) through the insulating connecting sheet.

2. The battery pack according to claim 1, wherein the flexible printed circuit board (201) comprises a flexible printed circuit board body (2011), a plurality of sampling sheets (202) are configured on the flexible printed circuit board body (2011) and distributed along a stacking direction of the pouch battery cells, and one of the sampling sheets (202) is fixedly welded to a tab of corresponding one of the pouch battery cells.

3. The battery pack according to claim 2, wherein the insulating connecting sheet comprises: a plastic sheet (204).

4. The battery pack according claim 3, wherein the flexible printed circuit board body (2011) is located at the tab side of the battery cell stack (102), the plastic sheet (204) comprises a first fixing surface (2041) and a second fixing surface (2042) connected to each other, the second fixing surface (2042) is fitted and connected to the flexible printed circuit board body (2011), and the first fixing surface (2041) is fitted and connected to an upper surface of the battery cell stack (102) to fix the flexible printed circuit board body (2011).

5. The battery pack according to claim 4, wherein the first fixing surface (2041) is provided with a plurality of first openings (2043), the first openings (2043) are located near a connection between the first fixing surface (2041) and the second fixing surface (2042), and corresponds to the sampling sheets (202).

6. The battery pack according to claim 4 or 5, wherein an angle between the first fixing surface (2041) and the second fixing surface (2042) is equal to an angle formed between the upper surface of the battery cell stack (102) and a surface on the tab side.

7. The battery pack according to claim 3, wherein the flexible printed circuit board body (2011) is adhesively fixed with the plastic sheet (204), and the plastic sheet (204) is adhesively fixed with the battery cell stack (102).

8. The battery pack according to claim 2, wherein the insulating connecting sheet comprises: a hot pressing film (209).

9. The battery pack according to claim 8, wherein the hot pressing film (209) comprises a first hot pressing film (2091) and a second hot pressing film (2092), at least a part of the flexible printed circuit board body (2011) and at least a part of the sampling sheets (202) are pressed between the first hot pressing film (2091) and the second hot pressing film (2092).

10. The battery pack according to claim 9, wherein the flexible printed circuit board body (2011) is located on an upper surface side of the battery cell stack (102), one end of each of the sampling sheets (202) is fixedly connected to the flexible printed circuit board body (2011), and the other end of each of the sampling sheets (202) is bent to form a vertical part (2021), the vertical part (2021) extends to the tab side of the battery cell stack (102), and a part of the vertical part (2021) extends beyond the first hot pressing film (2091) and the second hot pressing film (2092) and is fixedly welded to the tab of the corresponding one of the pouch battery cells.

11. The battery pack according to claim 10, wherein the first hot pressing film (2091) and the second hot pressing film (2092) both include a first hot pressing surface (2093) and a second hot pressing surface (2094), and an angle formed between the first hot pressing surfacee (2093) and the second hot pressing surface (2094) is equal to an angle formed between the upper surface of the battery cell stack (102) and a surface on the tab side.

12. The battery pack according to claim 10 or 11, wherein a plurality of first protrusions (2014) are configured on the flexible printed circuit board body (2011), a temperature sampling terminal (205) is configured on one of the first protrusions (2014), the first hot pressing film (2091) and the second hot pressing film (2092) are respectively located on an external side and an inner side of the flexible printed circuit board body (2011), and second protrusions (2095) corresponding to the first protrusions (2014) are configured on the first hot pressing film (2091), the first protrusions (2014) are pressed by the second protrusions (2095) so that the temperature sampling terminal (205) is configured on the upper surface of the battery cell stack (102), and through holes corresponding to the temperature sampling terminal (205) are configured on the second protrusions (2095).

13. The battery pack according to claim 2, wherein side panels (104) is further configured in the lower housing (101), the side panels (104) are located on two sides of the battery cell stack (102) along the stacking direction of the pouch battery cells, two ends of the flexible printed circuit board body (2011) are bent in a same direction to form a fixing part (2012) stuck on the side panels (104).

14. The battery pack according to claim 13, wherein the flexible printed circuit board assembly (200) further comprises a first connector (203), the first connector (203) is configured on the fixing part (2012) and is adapted to be electrically connected to a battery management system (108).

15. The battery pack according to claim 13, further comprising: a temperature sampling terminal (205) and a fixing plate (207), wherein the temperature sampling terminal (205) is fixedly connected to the battery cell stack (102) through the fixing plate (207).

16. The battery pack according to claim 15, wherein two ends of the fixing plate (207) extend along the stacking direction of the pouch battery cells within the battery cell stack (102), and are fixedly connected to corresponding one of the side panels (104).

17. The battery pack according to claim 15, wherein the flexible printed circuit board body (2011) is located at the tab side of the battery cell stack (102), and the temperature sampling terminal (205) is located at an upper surface side of the battery cell stack (102), the flexible printed circuit board (201) further comprises a plurality of extending structures (213), and two ends of the extending structures (213) are connected to the flexible printed circuit board body (2011) and the temperature sampling terminal (205) respectively.

18. The battery pack according to claim 17, wherein a reinforcement plate is configured at one end of the extending structures (213) connected to the temperature sampling terminal (205), and the reinforcement plate and the temperature sampling terminal (205) are located on opposite sides of the extending structures (213), the reinforcement plate faces the upper surface of the battery cell stack (102), the fixing plate (207) is provided with a second opening (2072) corresponding to the temperature sampling terminal (205), and the fixing plate (207) is pressed on the extending structures (213) and/or the reinforcement plate and fits with the upper surface of the battery cell stack (102).

19. The battery pack according to any of claims 15-18, wherein the two ends of the fixing plate (207) are bent in a same direction to form a bent structure (2071), and the bent structure (2071) is fixedly connected with the side panels (104).
